Europäisches Patentamt

European Patent Office

Office européen des brevets

(11) Publication number: **0 514 032 A1**

## EUROPEAN PATENT APPLICATION

(21) Application number: **92303690.9**

(22) Date of filing: **24.04.92**

(51) Int. Cl.⁵: **B32B 15/04**, B32B 15/18, B32B 18/00, C23C 16/26

(30) Priority: **17.05.91 IL 98174**

(43) Date of publication of application:
**19.11.92 Bulletin 92/47**

(84) Designated Contracting States:
**AT DE FR GB IT SE**

(71) Applicant: **ISCAR LTD.**
**P.O. Box 11**
**Migdal, Tefen 24959(IL)**

(72) Inventor: **Porat, Reuven**
**28 Wolfson Street**
**Nahariya 22406(IL)**

(74) Representative: **Sturt, Clifford Mark et al**
**J. MILLER & CO. 34 Bedford Row Holborn**
**London WC1R 4JH(GB)**

(54) Chemical vapor deposition of diamond coatings on hard substrates.

(57) There is provided a wear-resistant composite coated article comprising a hard substrate selected from cemented carbides, TiCN-based sintered Cermet, ceramic materials and steels, a first coating layer applied by chemical vapour deposition and consisting of a pure metal of the groups Vb and VIb of the Periodic Table, or a carbide or nitride thereof, and an outer coating layer of diamond applied by chemical vapour deposition.

## BACKGROUND OF THE INVENTION

This invention relates to composite articles comprising a hard substrate with a coherent outer surface coating of diamond. The invention further relates to a method for the application by chemical vapour deposition of such a coherent diamond coating onto a hard substrate. In particular, the invention provides diamond coated cutting tools, drill bits and the like made of cemented carbides, Cermet, ceramic materials, steel and the like having improved hardness and wear resistance.

Diamond has always been of great interest for industrial applications owing to its high hardness, high heat conductivity, inertness to chemical attack and wear resistance. However, such industrial applications were restricted, due to the prohibitively high cost of natural and synthetic diamonds. In the last few decades, methods have been developed for the low-pressure chemical vapour deposition (hereinafter "CVD") of diamond on various substrates which enabled the application of such diamond coated articles for cutting, grinding, polishing, etc. at considerably lower costs. Various techniques were developed for the low-pressure CVD of diamond, the most important ones being the hot filament assisted CVD (using a tungsten or tantalum filament) and the plasma activated CVD (using microwave and radio-frequency plasma). The first-mentioned "hot filament" method will be described in connection with the present invention, it being understood that the invention is not limited thereto.

It has been found that coherent diamond coatings can be applied by CVD on carbide-forming metals, metal carbides, metal nitrides and metal carbonitrides. Against this, substrates consisting of metals which do not form carbides (e.g. cobalt and nickel), metal oxides such as alumina and zirconia, and various types of steels, are not suitable for CVD of diamond, preventing complete adherence of the coating to the substrate. In particular, diamond deposition on cemented carbides suffers from the poor adhesion of the diamond coating to the substrate owing to the presence of cobalt as a binder in the cemented carbides. To solve this problem, it has been proposed to reduce the cobalt content of the of the cemented carbide surface which is to be coated or to eliminate the cobalt entirely from that surface, by chemical etching (e.g. with sulfuric or nitric acids) or by physical pre-treatment of the cemented carbide surface, e.g. scratching or vigorous mechanical spraying. These methods, however, suffer from the drawback that the surface zone of the cemented carbide from which the cobalt has been depleted, is porous and of poor mechanical strength and, while the diamond coating is deposited on the carbide surface, it is not firmly bonded to the body of the substrate itself and is dislocated comparatively easily together with the surface layer of the cobalt-free carbide.

Another solution for the coating of cemented carbides with diamond, is to apply a diamond coating on a foil of a refractory metal, e.g. tungsten, which foil is thereafter bonded to the cemented carbide substrate by brazing.

Similar problems are encountered when it is tried to deposit a diamond coating layer on a substrate of ceramic material based on oxides and additives. There is no affinity between the ceramic article and the diamond coating and no integral bonding is created between the two. This problem is especially disturbing when semi-conductors are coated with a layer of diamond functioning as a heat sink to remove the great amount of heat generated in such semi-conductors. When the diamond coating is not perfectly bonded to the semi-conductor substrate, the efficiency of the heat transport is considerably decreased.

Steels are also not suitable for coating with diamond because the high affinity between the diamond and the steel brings about the dissolution of the diamond in the metal.

Good results were obtained in the CVD of diamond on silicon, silicon carbide and silicon nitride.

## DESCRIPTION OF THE INVENTION

It has now been surprisingly found in accordance with the present invention that thin coherent coatings of diamond can be applied by CVD onto various hard metal and ceramic substrates, provided that those substrates are first coated with a thin intermediate layer, applied by CVD and consisting of a pure metal of the groups Vb and VIb of the Periodic Table, or a carbide or nitride thereof.

The invention thus provides a wear-resistant composite coated article comprising a hard substrate selected from cemented carbides, TiCN-based sintered Cermet, ceramic materials and steels, a first coating layer applied by chemical vapour deposition and consisting of a pure metal of the groups Vb and VIb of the Periodic Table, or a carbide or nitride thereof, and an outer coating layer of diamond applied by chemical vapour deposition.

The substrates which can be coated with diamond in the above manner are:

(1) Cemented carbides based on tungsten carbide with cobalt as a binder and optional additives of cubic carbides;

(2) Cermet materials based on titanium carbonitride with cobalt and nickel as binders, with the addition of cubic carbides;

(3) Ceramic materials based on oxides such as aluminum oxide, possibly with additives selected from carbides, nitrides, oxides and carbonitrides of W; Mo; Ti; V; Zr; Hf; Ta; Nb; Cr; and Mg.

(4) Steels, particularly high speed steels and alloy steels.

The group Va and VIa metals which are suitable according to the present invention to deposit the intermediate layer are tantalum, molybdenum, vanadium, tungsten, chromium and niobium. Suitably, the intermediate layer may consist of carbides or nitrides of these elements, including non-stroichiometric carbides and nitrides.

As stated above, the intermediate layer is applied onto the surface of the substrate by CVD in accordance with known procedures. (cf., for example, U.S. Patent 3,552,939 and 3,640,689, Canadian Patent 1083900 and U.S. Patent 4,728,579 as well as K.A. Gesheva and G.S. Beshkoe in Journal de Physique, Vol. 50 [May, 1989]). As will be shown in the examples hereinbelow, a coating layer of a group Vb or VIb metal, applied by CVD, can be transformed into the corresponding carbide or nitride by heating in a suitable atmosphere under controlled conditions. For example, a tungsten coating layer can be transformed into a layer of WC or $W_2C$, the carbon being supplied either from a hydrocarbon gas (e.g. methane) or by diffusion from a carbon containing substrate, particularly cemented carbide or steel.

On top of the intermediate layer there is deposited, according to the invention, a thin diamond coating by hot filament assisted chemical vapour deposition. This technique is already well-known and reference may be made, inter-alia, to R. Haubner and B. Lux in Journal de Physique, Vol. 50 (May 1989) and literature references mentioned therein; X.X. Pan, R. Haubner and B. Lux in First Euro. Conf. Diamond and Diamond-Like Carbon Coatings, September 17-19, 1990; "Low-pressure synthesis of super hard coatings", B. Lux and R. Haubner, Refractory Metals and Hard Materials, Vol. 8, No. 3, September 1989; Kunio Shibuki et al., Surface and Coatings Technology, 36 (1988), pages 295-302.

The adhesion strength of the diamond coating to the substrate was measured by indentation with a Rockwell hardness diamond cone. The cutting performance of diamond-coated cutting tools according to the present invention was examined by machining various workpieces. It has been found that diamond coatings deposited on an intermediate layer according to the invention exhibited a much better adhesion strength and wear resistance as compared to diamond coating layers of the same thickness deposited directly on the substrate.

The invention will be described herein in detail in the following, non-limiting examples.

## Example 1:

Deposition of intermediate layer of tungsten and its compounds

The substrate is placed in a CVD reactor, heated to 360°C at a pressure of 900 mbar. A 6% mixture of W-$(CO)_6$ in argon is fed into the reactor from a generator heated to 93°C. After 90 mins. deposition, a tungsten coating having a thickness of 2 $\mu$m was obtained. The coating layer includes small amounts of oxygen and carbon impurities derived from the tungsten hexacarbonyl.

Where the substrate is a sintered carbide (WC + Co) or Cermet based on TiCN, the tungsten coating can be transformed into various tungsten compounds, for example:

1. Heating of the coated substrates at a temperature of 950°C in a hydrogen atmosphere under atmospheric pressure for 60 minutes yields a 2 $\mu$m layer of pure tungsten. This process is also applicable to ceramic materials, and steels.

2. A coated cemented carbide substrate is heated to 1150°C at a vacuum of $3x10^{-7}$ bar for 60 minutes whereby the tungsten coating layer is transformed into $W_2C$.

3. Heating of a tungsten-coated cemented carbide substrate at 1270°C at a vacuum of $3 \times 10^{-7}$ bar for 60 minutes converts the tungsten coating layer to a layer of WC.

4. By heating the tungsten-coated substrate to a temperature of 950°C in an atmosphere of hydrogen containing 10% methane ($CH_4$) at a pressure of 70 mbar for 240 minutes, the coating layer is transformed into a layer of $W_2C$.

## Example 2:

Deposition of an intermediate layer of tantalum and its compounds

The substrate is put into a CVD reactor, heated to 750°C at a pressure of 800 mbar. The reactor is connected to a generator heated to 140°C containing tantalum pentachloride $TaCl_5$. A stream of a gas mixture of 5% $TaCl_5$, 30% argon and 65% hydrogen at a pressure of 80 mbar is fed into the reactor. After 90 minutes there is obtained a coating layer of tantalum having a thickness of 2 $\mu$m.

If the above procedure is repeated with the addition of 15% nitrogen to the gaseous mixture fed to the reactor, a coating of tantalum nitride is obtained.

If the above procedure is repeated with the addition of 10% of methane ($CH_4$) to the gas fed to the reactor, a coating of tantalum carbide is obtained.

**Example 3:**

Deposition of intermediate layer of vanadium carbide

A coating of vanadium carbide can be applied to a substrate by a similar procedure to the deposition of tantalum carbide above. The generator is charged with $VCl_4$ and the gases fed to the reactor include 10% of methane $CH_4$. The coating operation is conducted at a temperature of 940°C.

**Example 4:**

Deposition of a molybdenum intermediate layer

A molybdenum coating can be deposited on sintered carbide, sintered Cermet, alumina and high speed steel substrates by a procedure similar to that described in Example 1 above, using $Mo(CO)_6$. The coating is carried out at a comparatively low temperature of 360°C for 90 minutes followed by heating in a hydrogen atmosphere to 950°C for 60 minutes. Under these conditions, coherent coatings of molybdenum are obtained, the thickness being dependent on the substrate. Thus, on a Cermet substrate a 3 $\mu$m thick layer of molybdenum is obtained. On cemented carbides and on high speed steel M2, coatings of a thickness of 2 $\mu$m are obtained, whereas on alumina-based ceramic bodies a coating of molybdenum having a thickness of 1.5 $\mu$m is obtained.

**Example 5:**

Deposition of diamond coatings

Substrates:
(1) Cemented carbide ISO K 15 consisting of 92.2% WC + 1.8% TaC + 0.2% NbC + 5.8% Co.
(2) Cemented carbide ISO K 15 coated by an intermediate layer of $W_2C$ having a thickness of 2 $\mu$m.
(3) Cermet for the application range ISO P 10 consisting of 40% TiCN + 8% $Mo_2C$ + 6% VC + 11% WC + 8.3% TaC + 2.7% NbC + 5.4% Ni + 7.6% Co.
(4) Cermet according to (3) above, coated with a 1.5 $\mu$m layer of WC.
(5) A ceramic body consisting of 80% $Al_2O_3$ + 0.5% MgO + 19.5% $ZrO_2$.
(6) A ceramic body having the composition as in (5) above, coated with a 3 $\mu$m thick layer of molybdenum.
(7) High speed steel M2 consisting of 4% Cr, 5% Mo, 65% W, 2% V, 0.9% C and Fe, coated with a 2 $\mu$m thick layer of molybdenum.

Preconditioning of the surface of the substrates

Substrates Nos. (1), (3) and (5) above were polished in an automatic polishing machine with diamond powder of a size 6-9 $\mu$ mixed with glycerin.

Deposition of diamond layer

1. By the hot filament method
    The samples were inserted into a laboratory coating oven and were coated under the following conditions: a tungsten filament was heated to 2100° at a pressure of 38 Torr, the substrate temperature being 890°C. Heating for 60 minutes in a hydrogen atmosphere containing 0.6% methane, yielded a dense coherent layer having a thickness of 6 $\mu$m (as measured on a cemented carbide sample coated with $W_2C$).

4

2. By the microwave method

The samples were placed in a coating chamber activated by a microwave generator at an output of 2.45 GHz. The samples were heated to 930°C and the pressure was 76 Torr in a hydrogen atmosphere containing 0.8% methane. After 170 minutes there was obtained a dense diamond coating layer having a thickness of 6 $\mu$m (as measured on a cemented carbide sample coated with $W_2C$).

**Example 7:**

Testing methods

A. Adhesion strength by Rockwell A method

The samples were tested for the adhesion strength of the diamond coating to the substrate by indentation with a diamond cone in accordance with the Rockwell A method with a load of 45 Kg (instead of 60 Kg in accordance with Rockwell A). The indentation was examined through a microscope at a magnification of x 80.

In samples with good adhesion between the coating and the substrate, no signs of destruction were detected.

In samples where the adhesion was good but certain destruction occurred beneath the coating, radial cracks could be observed. In samples where the diamond coating was incompletely bonded to the substrate, there were observed fractures of the coating in the form of a full or partial circular ring.

The results obtained with the above-described samples are summarised in the following Table I:

TABLE 1

| Sample No. | Cemented Carbide | Cemented Carbide + 2 μm W₂C | Cermet | Cermet + WC (1.5 μm) | Al₂O₃+ZrO₂ | Al₂O₃+ZrO₂ +3 μm Mo |
|---|---|---|---|---|---|---|
| Hot Filament | Indentation and full circular flaking off | Indentation without destruction | Indentation and circular flaking off | Indentation without destruction | Indentation with radial cracks and circular flaking off | Indentation and radial cracks |
| Microwave | Indentation and partial circular flaking off | Indentation without destruction | Indentation and circular flaking off | Indentation without destruction | Indentation radial cracks and circular flaking off | Indentation, and radial cracks |

Summary: Substrates made of cemented carbide, Cermet, ceramic materials and tool steels can be successfully coated with diamond by the hot filament or microwave CVD, by use of the above-described intermediate layers. Tools of cemented carbide coated in this manner exhibit tool life in silicon rich aluminum turning, comparable to tools made of brazed polycrystalline diamond.

B. Machining tests for coated cemented carbides

Machining tests were carried out on workpieces of silicon-enriched aluminum (12% Si), by turning under the following conditions:

Tool geometry TPG 331 (r = 0.4 mm)
Velocity V = 900 m/min
Chip depth a = 1.5 mm
Feed f = 0.08 mm/rev
The results are summarised in the following Table 2:

Table 2

| Coating Process | Cutting Tool | Tool Life min. |
|---|---|---|
| Hot Filament | ISO K 15 + 2$\mu$m $W_2C$ + 6$\mu$m Diamond CVD Coating | 20 |
| Microwave | ISO K 15 + 2$\mu$M $W_2C$ + 6$\mu$m Diamond CVD Coating | 16 |
| Hot Filament | ISO K 15 + 6$\mu$m Diamond CVD Coating | 2 |
| Microwave | ISO K 15 + 6$\mu$m Diamond CVD Coating | 4 |
| ------- | ISO K 15 + Polycrystalline Diamond (PCD) Brazed | 26 |

The criterion for the tool life was its surface quality, until the surface quality was worse than 1.5 $\mu$m CLA (Center line average). A very good correlation was found between the indentation tests and the machining tests.

## Example 8:

Test for the efficiency of diamond coating on steel

The test was carried out by a slotting milling cutter to make slots in wood. Slot diameter was 75 mm, slot width 12.7 mm. The milling cutter had four straight horizontal teeth with a tooth angle of $\alpha = 18°$ and $\gamma = 6°$. The test was conducted on oak wood parallel to the grain at a slot width of 12.7 mm and depth of 6.35 mm. The tested parameter was the maximal machining velocity which can be used before the wood starts to burn.

The following milling cutters having identical geometries were tested:
1) - A steel milling cutter having brazed teeth of polycrystalline diamond.
2) - A steel milling cutter having brazed teeth of cemented carbide ISO K10.
3) - A milling cutter of high speed steel M2 of the composition: 4% Cr; 5% Mo; 6.5% W; 2% V; 0.9% C and the balance Fe. This milling cutter was coated with an intermediate layer of molybdenum at a thickness of 2 $\mu$m and the four teeth only were then coated with a diamond layer by the hot filament assisted CVD method. Before the coating the steel was annealed at a hardness Rc 59-62 and after the coating with molybdenum and diamond at 890°C and fast cooling under nitrogen, the hardness of the substrate remained in this range of 53-55 Rc.
4) - An uncoated milling cutter of high speed steel M2.

The results are summarised in the following Table 3:

Table 3

| Type of Tool | Maximum Speed M/MIN until the wood starts to burn |
|---|---|
| 1) Milling cutter with teeth of polycrystalline diamond | 850 |
| 2) Milling cutter with teeth of cemented carbide ISO K 10 | 300 |
| 3) Milling cutter of high speed steel M2 coated with diamond over an intermediate layer of Mo | 570 |
| 4) Milling cutter of high speed steel M2 uncoated | 120 * |

* At this speed no burning occurred, but rather destruction of the tool owing to immediate collapse of mechanical properties caused by the high temperature.

Results: The excellent heat conductivity in combination with the high hardness of the diamond coating on the steel substrate,enables the working of wood at high milling velocities, with the retention of the properties of the steel and without burning of the wood.

**Claims**

1. A wear-resistant composite coated article comprising a hard substrate selected from cemented carbides, TiCN-based sintered Cermet, ceramic materials and steels, a first coating layer applied by chemical vapour deposition and consisting of a pure metal of the groups Vb and Vlb of the Periodic Table, or a carbide or nitride thereof, and an outer coating layer of diamond applied by chemical vapour deposition.

2. An article according to Claim 1, in which the intermediate layer has a thickness of 0.5-20 $\mu$m, especially about 2 $\mu$m.

3. An article according to Claim 1 or 2, in which the substrate consists of cemented carbide comprising WC, TaC, NbC and optionally TiC in a cobalt matrix.

4. An article according to Claim 3, in which the intermediate layer consists of W, $W_2C$ or WC.

5. An article according to Claim 1 or 2, in which the substrate consists of TiC-based sintered Cermet.

6. An article according to Claim 5, in which the intermediate layer consists of W, $W_2C$ or WC.

7. An article according to Claim 1 or 2, in which the substrate consists of a ceramic material.

8. An article according to Claim 7, in which the intermediate layer consists of Mo, $Mo_2C$ or MoC.

9. An article according to Claim 1 or 2, in which the substrate consists of steel.

10. An article according to Claim 9, in which the intermediate layer consists of Mo, $Mo_2C$, MoC, W, $W_2C$ or WC.

11. A method of providing a coherent diamond coating onto a hard substrate selected from cemented carbides, TiC-based sintered Cermet, ceramic materials and steels, characterised in that an intermediate coating layer is first applied onto the substrate by chemical vapour deposition, said intermediate layer consisting of a metal of groups Vb or Vlb of the Periodic Table or a carbide or nitride thereof, whereafter the outer diamond coating is applied on said intermediate layer by chemical vapour deposition.

12. A method according to Claim 11, wherein the intermediate layer has a thickness of 0.5-20 $\mu$m, especially about 2 $\mu$m.

13. A method according to Claim 11 or 12, wherein the substrate consists of cemented carbide comprising WC, TaC, NbC and optionally TiC in a cobalt matrix.

14. A method according to Claim 13, wherein the intermediate layer consists of W, $W_2C$ or WC.

15. A method according to Claim 11 or 12, wherein the substrate consists of TiC-based sintered Cermet.

16. A method according to Claim 15, wherein the intermediate layer consists of W, $W_2C$ or WC.

17. A method according to Claim 11 or 12, wherein the substrate consists of a ceramic material.

18. A method according to Claim 17, wherein the intermediate layer consists of Mo, $Mo_2C$ or MoC.

19. A method according to Claim 11 or 12, wherein the substrate consists of steel.

20. A method according to Claim 19, wherein the intermediate layer consists of Mo, $Mo_2C$, MoC, W, $W_2C$ or WC.

| DOCUMENTS CONSIDERED TO BE RELEVANT | | | EP 92303690.9 |
|---|---|---|---|

| Category | Citation of document with indication, where appropriate, of relevant passages | Relevant to claim | CLASSIFICATION OF THE APPLICATION (Int. Cl.5) |
|---|---|---|---|
| X | DE - A - 3 522 583 (SANTRADE) * Claims 1,2,13; page 5, lines 32-35; page 10, line 37 - page 11, line 7; page 14, lines 32-35 * | 1-20 | B 32 B 15/04 B 32 B 15/18 B 32 B 18/00 C 23 C 16/26 |
| A | EP - A - 0 257 439 (SUMITOMO) * Page 3, lines 8-17 * | 1-20 | |
| A | EP - A - 0 251 264 (MITSUBISHI) * Column 1, line 35 - column 2, line 21 * | 1-20 | |

TECHNICAL FIELDS
SEARCHED (Int. Cl.5)

B 32 B 15/00
B 32 B 18/00
C 23 C 16/00

The present search report has been drawn up for all claims

| Place of search | Date of completion of the search | Examiner |
|---|---|---|
| VIENNA | 07-08-1992 | ONDER |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

......................................................................................................

& : member of the same patent family, corresponding
      document

EPO FORM 1503 03.82 (P0401)